# EUROPÄISCHE PATENTSCHRIFT

(11) **EP 0 309 823 B1**
(45) Veröffentlichungstag und Bekanntmachung des Hinweises auf die Patenterteilung: **05.01.1994**
(21) Anmeldenummer: 88115134.4
(22) Anmeldetag: 15.09.1988
(51) Int. Cl.: H05K 13/04

(54) **Bestückungskopf für oberflächenmontierbare Bauelemente**
Insertion head for surface-mounted components
Tête d'insertion pour composants à monter en surface

(30) Priorität: 28.09.1987 DE 8713041 U
(43) Veröffentlichungstag der Anmeldung: 05.04.1989
(73) Patentinhaber: SIEMENS AKTIENGESELLSCHAFT, 80333 München (DE)
(72) Erfinder: Gutmann, Klaus, Dipl.-Ing., D-8500 Nürnberg (DE)

(56) Entgegenhaltungen:
- EP-A- 0 155 512
- IBM TECHNICAL DISCLOSURE BULLETIN vol. 25, no. 7, Dezember 1982, NEW YORK (US) Seite 3423 - 3425; T.L. LEUNG: "Insertion head for multi-size square modules"

## Beschreibung

Die Erfindung bezieht sich auf einen Bestückungskopf für oberflächenmontierbare Bauelemente, wobei mindestens ein Greiferpaar und eine Vakuumpipette zum direkten Aufnehmen von Bauelementen einer ersten vorgegebenen maximalen Grundflächenabmessung vorgesehen ist, die mittels von einem ersten Minimalabstand um einen vorgegebenen Öffnungsweg zu einem ersten Maximalabstand verfahrbaren ersten Backen des Greiferpaares lagerichtig fixierbar sind, und wobei die Saugfläche vergrößernde Adapter zum Vorsetzen auf die Pipette vorgesehen sind, mittels derer Bauelemente einer vorgegebenen zweiten Grundflächenabmessung, die größer als die erste vorgegebene maximale Grundflächenabmessung ist, aufnehmbar sind.

Wenn Leiterplatten mit oberflächenmontierbaren Bauelementen zu bestücken sind, erfolgt dies durch Automaten, Ein derartiger Automat ist aus der im November 1985 veröffentlichten Siemens Druckshrift "SMD-Bestückungsautomat MS-72 Systembeschreibung" bekannt. Das Aufnehmen der Bauelemente erfolgt dabei mit Hilfe einer Vakuumpipette. Dazu senkt sich diese Pipette von oben auf das jeweilige Bauelement herab, hebt es dann an und mittels zweier Greiferpaare wird dann das Bauelement in seiner Lage zentriert und festgehalten. Anschließend wird das Bauelement in seine Bestückungsposition hin verfahren. Dort werden die Greiferpaare geöffnet und mit Hilfe der Pipette wird das Bauelement auf die Leiterplatte aufgesetzt.

Dieser Vorgang ist jedoch auf Bauelement mit einer maximalen Grundfläche von 14 mal 14 mm beschränkt. Sind großflächigere Bauelemente zu behandeln, werden diese mit einem saugkräftigeren Adapter aufgenommen, welcher der Pipette vorgesetzt wird. Für derartige großflächige Bauelemente, z.B. große ICs, ist allerdings ein Zentrieren mit den Zangenpaaren im Bereich der Pipette nicht möglich, da deren Spannweite überschritten wird. Deshalb werden diese Bauelemente in einer gesonderten Zentrierstation zur Pipette hin ausgerichtet. Dies bedingt zum einen einen erhöhten Verfahrweg, zum anderen sind diese größeren Bauelemente bei der Querbewegung des Bestückungskopfes nur mit Hilfe des Adapters gehalten und nicht durch die seitlich angreifenden Greifer zusätzlich fixiert. Dadurch ist die Geschwindigkeit, mit welcher der Bestückungskopf während des Bestückungsvorganges verfahren werden kann, erheblich eingeschränkt, wodurch die Verfügbarkeit des komplexen Bestückungsautomaten nicht unwesentlich reduziert wird.

Aus dem Dokument IBM Technical Disclosure Bulletin, Vol.25, No.7A, December 1982 ist es für Bestückungsköpfe der eingangs genannten Art bekannt, Adapter vorzusehen, die in ihrer Größe an die aufzunehmenden Bauteile angepaßt sind.

Ferner ist aus der EP-A-0 155 512 eine Anordnung von Greifern mit gestuften Backen bekannt.

Aufgabe der Erfindung ist es, einen Bestückungskopf der eingangs genannten Art so auszubilden, daß auch Bauelemente mit einer realtiv großen Grundfläche direkt am Bestückungskopf zentriert werden können und zwar so, daß diese Bauelemente während des Bestückungsvorganges durch die Greiferpaare fixiert werden können.

Gemäß der Erfindung wird diese Aufgabe dadurch gelöst, daß an jedem Greifer durch eine Stufung eine weitere Backe vorgesehen ist, daß die sich durch die weiteren Backen ergebenden Backenpaare zum Aufnehmen der Bauteile der vorgegebenen zweiten Grundflächenabmessung während des vorgegebenen Öffnungsweges von einem zweiten Minimalabstand zu einem zweiten Maximalabstand verfahrbar sind und daß dazu die weiteren Backen unmittelbar am, der Vakuumpipette abgewandten freien Ende der jeweiligen Greifer den ersten Backen vorgelagert sind. Bei einer solchen Anordnung kann die Pipette sowohl für große als auch kleine Bauelemente unverändert bleiben. Eine Steuerung der Pipette in verschiedenen Z-Achspositionen für die unterschiedlichen Backenpaare erübrigt sich. Allein die Adapterhöhe stellt sicher, daß das zuständige Backenpaar zum Einsatz kommt.

Ein Ausführungsbeispiel der Erfindung ist in der Zeichnung dargestellt und wird im folgenden näher erläutert. Dabei zeigen:
- FIG: 1 einen Bestückungskopf beim Aufnehmen eines großflächigen Bauelementes und

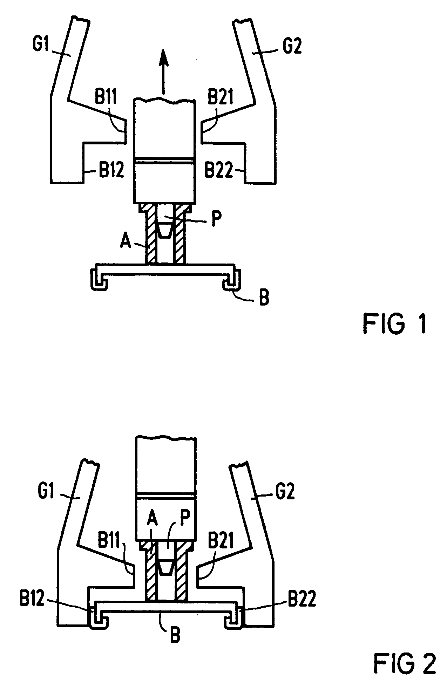

- FIG 2: den Bestückungskopf beim Verfahren des Bauelementes.

In der Darstellung gemäß FIG 1 ist der Übersichtlichkeit halber abschnittsweise ein Bestückungskopf für oberflächenmontierbare Bauelement, so das Bauelement B, gezeigt. Dieser Bestückungskopf besteht im wesentlichen aus einer Vakuumpipette P, zwei Greiferpaaren, von denen in der Darstellung die Greifer G1 und G2 eines der Greiferpaare dargestellt sind, sowie einem bedarfsweise aufsetzbaren Adapter A. Die Greifer G1 und G2 weisen Backenpaare B11 und B21 sowie B12 und B22 auf, mit deren Hilfe bei einem vorgegebenen Öffnungsweg der Greifer G1 und G2 Bauelemente seitlich gehalten werden können, sofern die Pipette nach dem Aufnehmen der Bauelemente (wie durch einen Pfeil angedeutet) angehoben worden ist. Dadurch werden diese Bauelemente in ihrer Lage zur Pipette P bzw. zum Adapter A zentriert und bleiben während des seitlichen Verfahrens des Bestückungskopfes stets fixiert.

Bauelemente, die nur mit der Pipette P ohne das Vorsetzen des Adapters A aufgenommen werden, werden mit Hilfe der Backen B11 und B21 gehalten. Bauelemente mit größerer Abmessung, wie das Bauelement B in der gewählten Darstellung, werden mit Hilfe der Backen B12 und B22 zentriert und gehalten.

In der Darstellung gemäß FIG 1 ist das Bauelement B nicht zentrisch zum Adapter A von diesem aufgenommen worden. In der Darstellung gemäß FIG 2 ist gezeigt, wie eine Zentrierung des Bauelementes B und ein seitliches Fixieren dieses Bauelementes für das seitliche Verfahren des Bestückungskopfes erfolgt ist. Die Pipette P ist angehoben worden und daraufhin sind die Greifer G1 und G2 zentrisch über eine der Übersichtlichkeit halber nicht dargestellte Führung seitlich gegen das Bauelement B gedrückt worden. Durch diese Kraft ist das Bauelement B von den Backen B12 und B22 zum Adapter A hin zentriert worden ist. Ein derartiges Verschieben des Bauelementes B gegenüber den Adapter A ist deshalb möglich, da es sich bei der Verbindung zwischen Bauelement B und Adapter A einzig und allein um einen vakuumbedingten Kraftschluß handelt, der mittels der auf die Greifer G1 und G2 wirkenden Kräfte überwindbar ist.

Die Länge der fingerartig auf die Bestückungsrichtung hin von den Greifern G1 und G2 zur Bauelementeseite hin ausgerichteten Backen B12 und B22 ist dabei der Länge des Adapters A angepaßt und innerhalb weiter Grenzen variierbar. Wenn allerdings die Spannweite zwischen den Backen B12 und B22 zur Aufnahme extrem großer Bauelemente nicht mehr ausreichen sollte, wäre es bei der Erfindung möglich, eine separate Zentrierstation, wie sie aus dem Stand der Technik bekannt ist, zusätzlich vorzusehen.

## Patentansprüche

1. Bestückungskopf für oberflächenmontierbare Bauelemente, wobei mindestens ein Greiferpaar (G1,G2) und eine Vakuumpipette (P) zum direkten Aufnehmen von Bauelementen (B) einer ersten vorgegebenen maximalen Grundflächenmessung vorgesehen ist, die mittels von einem ersten Minimalabstand um einen vorgegebenen Öffnungsweg zu einem ersten Maximalabstand verfahrbaren ersten Backen (B11,B21) des Greiferpaares (G1,G2) lagerichtig fixierbar sind, und wobei die Saugfläche vergrößernde Adapter (A) zum Vorsetzen auf die Pipette (P) vorgesehen sind, mittels derer Bauelemente (B) einer vorgegebenen zweiten Grundflächenabmessung, die größer als die erste vorgegebene maximale Grundflächenabmessung ist, aufnehmbar sind, **dadurch gekennzeichnet,** daß an jedem Greifer (G1,G2) durch eine Stufung eine weitere Backe (B12,B22) vorgesehen ist, daß die sich durch die weiteren Backen (B12,B22) ergebenden Backenpaare zum Aufnehmen der Bauteile (B) der vorgegebenen zweiten Grundflächenabmessung während des vorgegebenen Öffnungsweges von einem zweiten Minimalabstand zu einem zweiten Maximalabstand verfahrbar sind und daß dazu die weiteren Backen (B12,B22) unmittelbar am freien, der Vakuumpipette abgewandten Ende der jeweiligen Greifer (G1,G2) den ersten Backen (B11,B12) vorgelagert sind.

## Claims

1. Insertion head for surface-mounted components, whereby at least one pair of grippers (G1, G2) and a vacuum pipette (P) are provided for directly picking up components (B) of a first pre-determined maximum measurement of surface area, which components can be placed in the correct position by means of first jaws (B11, B21) of the pair of grippers (G1, G2), which first jaws can be moved by a pre-determined opening distance from a first minimum spacing to a first maximum spacing, and whereby adapters (A) increasing the suction surface are provided for placing on the pipette (P) beforehand, by means of which adapters components (B) of a pre-determined second surface area measurement, which is greater than the first pre-determined maximum surface area measurement, can be picked up,
characterised in that a further jaw (B12, B22) is provided on each gripper (G1, G2) by means of a step, in that the pairs of jaws resulting from the further jaws (B12, B22) can be moved, for picking up the components (B) of the pre-determined second surface area measurement, during the pre-determined opening travel, from a second minimum spacing to a second maximum spacing, and in that, for this purpose, the further jaws (B12, B22) are located directly at the free end of the respective grippers (G1, G2) facing away from the vacuum pipette, in front of the first jaws (B11, B12).

## Revendications

1. Tête d'équipement pour des composants pouvant être montés en surface, dans laquelle au moins un couple d'organes (G1,G2) de préhension et une pipette à dépression (P) sont prévus pour saisir directement des composants (B), dont la surface de base possède une première dimension maximale prédéterminée et qui peuvent être fixés dans une position correcte au moyen de premières mâchoires (B11,B21) du couple d'organes (G1,G2) de préhension, ces mâchoires étant déplaçables depuis une première distance minimale jusqu'à une première distance maximale, sur une distance d'ouverture prédéterminée, et dans laquelle, pour le prépositionnement, il est prévu, sur la pipette (P), des adaptateurs (A) qui augmentent la surface d'aspiration et à l'aide desquels des composants (B), dont la surface de base possède une seconde dimension prédéterminée qui est supérieure à la première dimension maximale prédéterminée de la surface de base, peuvent être saisis, caractérisée par le fait que sur chaque organe de préhension (G1,G2) est formée, grâce à la présence d'un épaulement, une autre mâchoire (B12,B22), que les couples de mâchoires, qui sont formées avec lesdites autres mâchoires (B12,B22) et qui servent à saisir les composants (B), dont la surface de base possède la seconde dimension prédéterminée, sont déplaçables, sur la distance d'ouverture prédéterminée, entre une seconde distance minimale et une seconde distance maximale, et qu'à cet effet lesdites autres mâchoires (B12,B22) sont montées devant les premières mâchoires (B11,B21), directement sur l'extrémité libre, tournée à l'opposé de la pipette à dépression, des organes de préhension respectifs (G1,G2).
